# EUROPEAN PATENT SPECIFICATION

(11) **EP 1 502 311 B1**
(45) Date of publication and mention of the grant of the patent: **03.12.2014**
(21) Application number: 03727418.0
(22) Date of filing: 30.04.2003
(51) Int. Cl.: H01L 51/52

(54) **ORGANIC DEVICE**
ORGANISCHE VORRICHTUNG
DISPOSITIF ORGANIQUE

(30) Priority: 07.05.2002 US 142208; 17.04.2003 US 249533
(43) Date of publication of application: 02.02.2005
(73) Proprietor: OSRAM Opto Semiconductors GmbH, 93055 Regensburg (DE)
(72) Inventor: Chong, Shi Chai, Bkt. Mertajam, 14000 Penang (MY); GUENTHER, Ewald, Karl, Michael, 93128 Regenstauf (DE); LACEY, David, Mountain View, CA 94041 (US); Lim, Hooi Bin, 10400 Penang (MY); KLAUSMANN, Hagen, 80999 München (DE); Tan, Cheng Kooi, BM 14000 Penang (MY)
(74) Representative: Epping - Hermann - Fischer
(86) International application number: PCT/EP2003/004575
(87) International publication number: WO 2003/096440

(56) References cited:
- WO-A-98/53644
- US-A1- 2001 048 272
- PATENT ABSTRACTS OF JAPAN vol. 2000, no. 21, 3 August 2001 (2001-08-03) & JP 2001 102166 A (SANYO ELECTRIC CO LTD), 13 April 2001 (2001-04-13) -& US 6 590 337 B1 (NISHIKAWA RYUJI ET AL) 8 July 2003 (2003-07-08)

## Description

The present invention relates to fabrication of organic devices, such as electroluminescent or organic light emitting diode (OLED) devices. More particularly, the invention relates to the improved encapsulation for electroluminescent devices and in a further aspect the invention relates to homogeneous or uniform deposition of active organic materials.

A display with a flat display area comprising electrodes and an insulating membrane is described in JP 2001-102166 A, wherein the insulating membrane has the function of a buffering layer between a substrate and a protection case. The document discloses an OLED device, having a substrate, an active region and a cap bonding region surrounding the active region, wherein the substrate is prepared with a first electrode at least located in the active region and metal interconnections located outside the active region, a homogenous layer covering the metal interconnections in an area outside the active region of the substrate, wherein the homogenous layer comprises a non-conductive material, at least one organic layer comprising organic material, a second electrode, wherein the organic layer is sandwiched between the first electrode and the second electrode and the metal interconnections are coupled to the electrodes, a cap bonded to the cap bonding region.

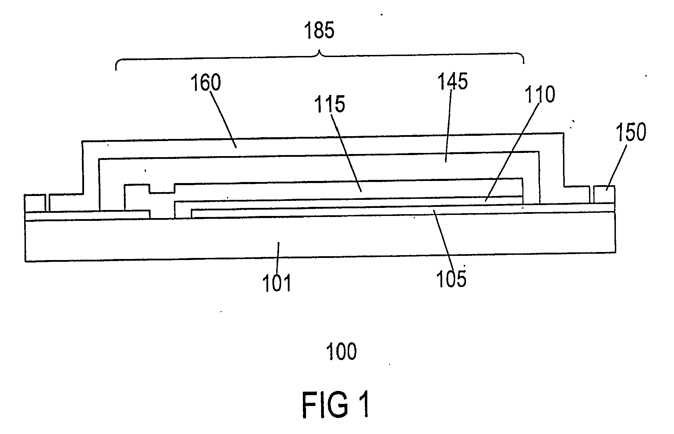

Fig. 1 shows a conventional electroluminescent device 100 having one or more OLED cells. An OLED cell includes a functional stack of one or more organic functional layers 110 between a transparent conductive layer 105 (e.g., indium tin oxide or ITO) and a conductive layer 115. The conductive layers serve as electrodes. The cells are fabricated in an active region 185 on a substrate 101. The cells can be configured as desired to form a display or lamp. A metallization layer which forms interconnections to the electrodes and bond pads 150 is provided. The bond pads are coupled to, for example, driving circuitry to control the operation of the OLED cells. A cap 160, which forms a cavity 145, encapsulates the device, hermetically sealing the OLED cells to protect them from the environment (e.g., moisture and/or air.)

In operation, charge carriers are injected through the electrodes for recombination in the functional layers. The recombination of the charge carriers causes the functional layer of the cells to emit visible radiation.

Techniques for depositing polymers include, for example, spin-coating or doctor blading. Such techniques coat the entire substrate surface. Since polymer materials are very soft and partially hygroscopic, they need to be completely removed from the area where the cap is bonded (e.g., cap bonding area) to the substrate. Furthermore, since bond pads are typically formed prior to the deposition of polymer materials, they need to be removed from above the bond pads in order to expose them for coupling to the driving circuitry.

However, limited techniques are available for patterning polymer materials. This is because most techniques which require chemistry (dry or wet) are incompatible with the sensitive polymer materials. A commonly used patterning technique is laser ablation. When laser ablation is used, high laser intensities and long irradiation times are required to remove the polymer materials from selected areas of the substrate. High laser intensities and long irradiation times can damage the metallization or ITO layer beneath the polymers, adversely affecting the device. Moreover, laser ablation may not be able to completely remove the polymer materials since optical absorption decreases as the layer becomes thinner. Incomplete removal of polymer materials from the cap bonding area can result in defective encapsulation, causing failures.

As evidenced from the above discussion, it is desirable to provide an electroluminescent device with reliable encapsulation.

Furthermore the organic functional layer of the OLED comprises, for example, a conjugated polymer which is dissolved in a solution. The polymer is deposited on the substrate by, for example, spin-coating or doctor blading techniques or other deposition/printing techniques. Generally, the organic layer is relatively thin, for example, about 50-400 nm. Since the organic layer is very thin, small deviations or non-uniformity in the layer can result in optical defects in device operation.

The organic layer coats the glass substrate which is prepared with patterned structures, such as metal interconnection and ITO electrode structures. The various structures create an uneven topography on the substrate surface. The various materials beneath have different surface energies, which, along with the substrate topography, make it difficult to provide a uniform organic layer.

To improve coating uniformity in the organic layer, various solutions have been proposed. Such solutions include, for example, treating the surface of the substrate by oxygen or plasma, selecting suitable metals to which the organic material exhibits good coating behavior, or modifying the organic material to produce good coating properties. However, such solutions have been ineffective because the good coating properties of the organic material is achieved by sacrificing manufacturability which results in higher manufacturing cost and/or performance degradation.

As evidenced from the above discussion, it is furthermore desirable to provide a uniform organic functional layer in organic devices, without adversely impacting device performance or increasing cost of manufacturing.

The invention relates to sealing for electroluminescent devices. The electroluminescent device includes a substrate with an active region on which at least one OLED cell is formed. A cap bonding region surrounds the active region.

In an additional aspect the invention relates to the uniform deposition of organic layers in organic devices. The organic device includes a substrate whereby at least one organic layer is deposited on the substrate, on top of other layers such as electrodes or metal interconnects. A homogenous layer, such as photoresist, which exhibits good coating property with active organic materials, is provided beneath the organic layer. This avoids the detrimental effect of the underlying metal, which could affect the uniform deposition of organic layer on the substrate, causing defects in, for example, OLED cells.

A process for fabricating an OLED device according to an embodiment of the invention comprises providing a substrate having an active region and a cap bonding region surrounding the active region, wherein the substrate is prepared with a first electrode at least located in the active region and metal interconnections located outside the active region. The process further comprises forming a homogenous layer covering the metal interconnections in an area outside the active region of the substrate, wherein the homogenous serves as a surface protection layer and comprises a non-conductive material, and wherein forming the homogenous layer comprises depositing a device layer over the substrate and patterning the device layer to form the homogenous layer in the area outside the active region. The process further comprises depositing at least one organic layer comprising organic material on the substrate by spin coating or doctor blading, and forming a second electrode, wherein the organic layer is sandwiched between the first electrode and the second electrode and the metal interconnections are coupled to the electrodes. The process further comprises removing the portions of the at least one organic layer in the area outside the active region, wherein the at least one organic layer is removed prior the formation of the second electrode, and mounting a cap to the cap bonding region. The homogenous layer promotes coating uniformity of the organic layer on the substrate (and hence reducing or preventing the adverse effect of metal. Furthermore, the homogenous layer allows removal of organic material from the at least one organic layer without damaging a layer below the homogenous layer.
Fig. 1 shows a conventional OLED device that can be fabricated by a method in accordance with the invention;
Fig. 2 shows an embodiment of the device that can be fabricated by a method in accordance with the invention;
Fig. 3 shows another embodiment of the device that can be fabricated by a method in accordance with the invention;
Figs. 4-9 show a process for fabricating an OLED device in accordance with one embodiment of the invention and
Figs. 10-14 show a process for fabricating an OLED device in accordance with another embodiment of the invention.

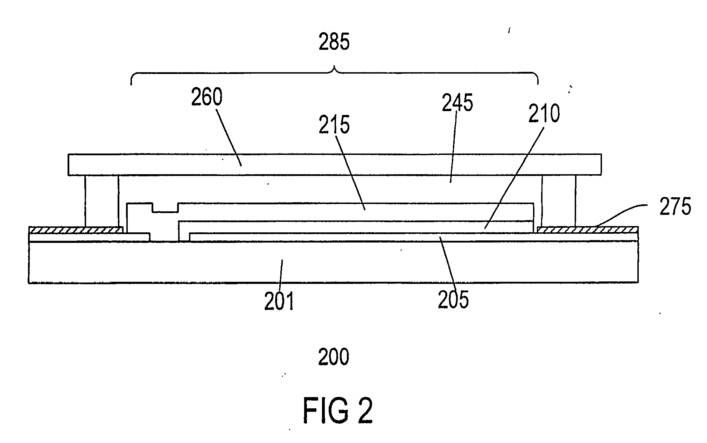

Fig. 2 shows an organic device 200 that can be fabricated by a method in accordance with the invention. The device comprises a substrate 201 having an active region 285 in which one or more active components are formed. The active components, in one embodiment, comprise an organic material. In one embodiment, the active component comprises one or more OLED cells, forming an OLED device. Providing other types of active components having organic material can also be useful to form other types of devices.

In one embodiment, the substrate comprises a transparent substrate, such as glass. Other types of transparent materials that can serve as a substrate to support the OLED cells are also useful. For example, plastic films can be used to serve as a substrate. Plastic materials are particularly useful to form flexible devices. The use of non-transparent materials for example Si is also useful, particularly for applications which view through the cap.

An OLED cell comprises one or more organic layers (organic stack) 210 sandwiched between first and second electrodes 205 and 215. Preferably, the organic layers comprise conjugated polymers. Other types of organic materials, such as low molecular materials, oligomers, starburst compounds or dendrimer materials, are also useful. Such materials include tris-(8-hydroxyquinolate)-aluminum (Alq), poly(p-phenylene vinylene) (PPV) or polyfluorene (PF). Other types of functional organic layers, including fluorescence or phosphorescence-based layers, are also useful. In one embodiment, a hole transport layer (HTL) is included in the organic stack 210. The HTL, for example, comprises a polymer blend, which typically contains polyaniline (Pani) or polythylenedioxythiophene (Pedot). The thickness of the organic stack is typically about 2 - 500 nm.

The first electrode 205 serves as, for example, the anode while the second electrode serves as the cathode. At least one of the electrodes comprises a transparent conductive material, such as indium tin oxide (ITO). The cathodes and anodes can be patterned as desired to form one or more OLED cells. For example, the cathodes and anodes are formed as strips in respective first and second directions, creating a pixelated device. Other patterns are also useful. Typically, the first and second directions are orthogonal to each other.

A cap 260 is bonded to the substrate in the cap bonding region surrounding the active region, encapsulating the OLED cells. The cap creates a cavity 245 to protect the cells from being damaged by physical contact with the cap.

The active area of the device can, for example, include shaped pillars (not shown) for patterning the device layers. The shaped pillars, which comprise an undercut, are used to pattern the top electrodes. The use of shaped pillars is described in, for example, "Production of Structured Electrodes" (US 2001/0017516A1) and "Patterning of Electrodes in OLED Devices" (PCT/SG00/00134).

The substrate includes conductive interconnects 205 located outside the active region 285. The interconnects comprise a metal. As previously described, the metal interconnects can adversely affect the uniformity of the organic layer. The unevenness of the organic layer may permeate from the areas outside the non-active region where the organic layer is in contact with the underlying metal layer into the active region, thus adversely affecting the active components.

In accordance with one embodiment of the invention, a homogenous layer 275 is provided on the substrate outside the active area. The homogenous layer covers the metal interconnects in the non-active region of the substrate. The homogenous layer comprises a material which promotes uniformity in the organic layer used to form the active components. By covering the metal interconnects, the adverse effect on the uniformity of the organic layer is reduced or prevented. The material comprises an insulating material to prevent shorting of the interconnects. For application where the material of the homogeneous layer is conducting, an insulating layer should be provided beneath the protective layer. More preferably, the homogenous layer is formed from a material which is compatible with the fabrication process of the device. For example, the material should be easily deposited on the substrate or easily removed selectively to expose portion of the underlying interconnects as desired. Preferably, the material can be deposited or easily be removed using processes which are already used in the fabrication of the devices, thus avoiding the need for additional tools or chemistry. In one embodiment, the homogenous layer comprises a photosensitve material, such as photoresist. Other types of photosensitive materials, for example polyimide, are also useful. Non-photosensitive materials such as resins or non-photosensitive polyimide, can also be used. Other types of materials having good coating behavior with organic materials can also be used. These include for example Novolak resin, polybenzoxazole, perylene.

The homogenous layer can also advantageously serve as a surface protection layer. For example, portions of the organic layer outside the active area may need to be removed, such as in the cap bonding region to promote adhesion between the cap and substrate or to expose the underlying metal interconnects for bond pads. Removal of the organic layer is typically achieved using laser ablation. However, the laser ablation process may damage the metal interconnects, rendering the device defective or adversely affecting its performance. By providing the homogenous layer beneath the organic layer, the metal interconnects can be protected from damage during the laser ablation process. The thickness of the homogenous layer should be sufficient to reduce or negate the adverse impact of the metal interconnects on the uniformity of the organic layer. Additionally, the homogenous layer should be sufficiently thick to protect the underlying layers from damage during process for selectively removing the polymer material. Typically, the thickness is about 0.5 - 2µm. Other thicknesses may also be useful.

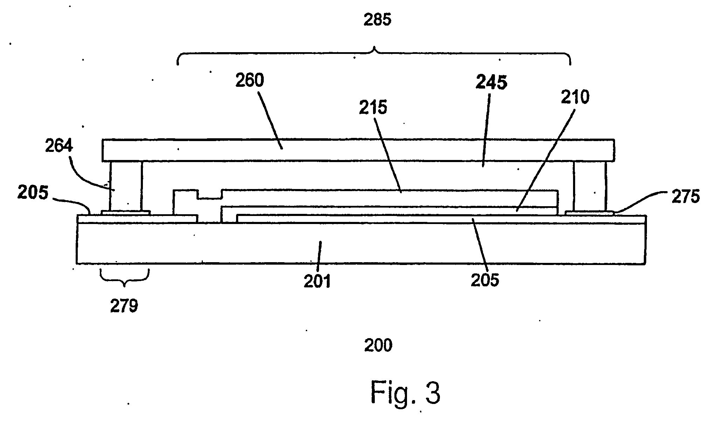

Fig. 3 shows an electroluminescent device 200 in accordance with another embodiment of the invention. The device comprises a substrate 201 having an active region 285 in which one or more OLED cells are formed. In one embodiment, the substrate comprises the same material as the substrate of the electroluminescent device shown in Fig. 2.

The OLED cell shown in Fig. 3 also can comprise the same functional stack as the device of Fig. 2, consisting of one or more organic layers (polymer stack) 210 sandwiched between first and second electrodes 205 and 215.

The cathodes and anodes can be patterned as desired to form one or more OLED cells in the same way as described for the device of Fig. 2. Bond pads 250 are electrically coupled to the cathodes and anodes.

A cap 260 is bonded to the substrate in the cap bonding region surrounding the active region, encapsulating the OLED cells. The cap creates a cavity 245 to protect the cells from being damaged by physical contact with the cap. In one embodiment, the cap comprises a cap substrate with a sealing rim or gasket formed thereon. The cap substrate can be formed from, for example, glass. Other materials which can serve as a cap substrate, such as metal or ceramic, can also be used. The sealing rim, for example, can be formed from photoresist. Other types of materials, such as silicate glass, silicon-dioxide, or ceramic can also be used. An adhesive is used to bond the cap to the substrate. The adhesive, for example, comprises resins based on epoxy, silicone, urethane, acrylate or olefinic chemistries. The resin can be a UV or thermally curable resin. Providing a sealing rim formed from an epoxy adhesive is also useful. Alternatively, the cap is a pre-formed cap comprising, for example, pressed metal or etched glass.

The active area of the device can, for example, include shaped pillars. The shaped pillars, which comprise an undercut, are used to pattern the top electrodes. The use of shaped pillars is described in, for example, "Production of Structured Electrodes"

(US 2001/0017516A1) and "Patterning of Electrodes in OLED Devices"(PCT/SG00/00134). Alternatively or in addition to shaped pillars, spacer particles can be provided on the substrate. The spacer particles serve to support the cap, preventing it from contacting the OLED cells. The use of spacer particles is described in, for example, "Encapsulation of Electronic Devices" (USSN 09/989362); "Improved Encapsulation of Organic LED devices"(PCT/SG99/00145); "Organic LED Device with Improved Encapsulation" (PCT/SG99/00143); and "Improved Encapsulation for Organic LED Device"(PCT/SG99/00145).

In accordance with one embodiment of the invention, a surface protection layer 275 is provided on the substrate in the cap bonding area. The cap contacts the surface protection layer. Various layers beneath the surface protection layer, for example, metal interconnects for the electrodes and/or electrodes such as ITO, are protected from damage during removal of the polymer material. Since the surface protection layer serves as part of the encapsulation, it should exhibit sufficient mechanical stability, good adhesion properties and low permeation rates to ensure good sealing between the cap and substrate. If the surface protection layer is directly over metal interconnects, it should be formed from an insulating material. Preferably, the surface protection layer is formed from a material which is compatible with the OLED fabrication process. Typically, the thickness of the surface protection layer is about 0.5-50um. Other thicknesses may also be useful. In one embodiment, the surface protection layer comprises photoresist. Other types of photosensitive materials, such as polyimide, are also useful. Non-photosensitive materials, such as resins or non-photosensitive polyimide, can also be used.

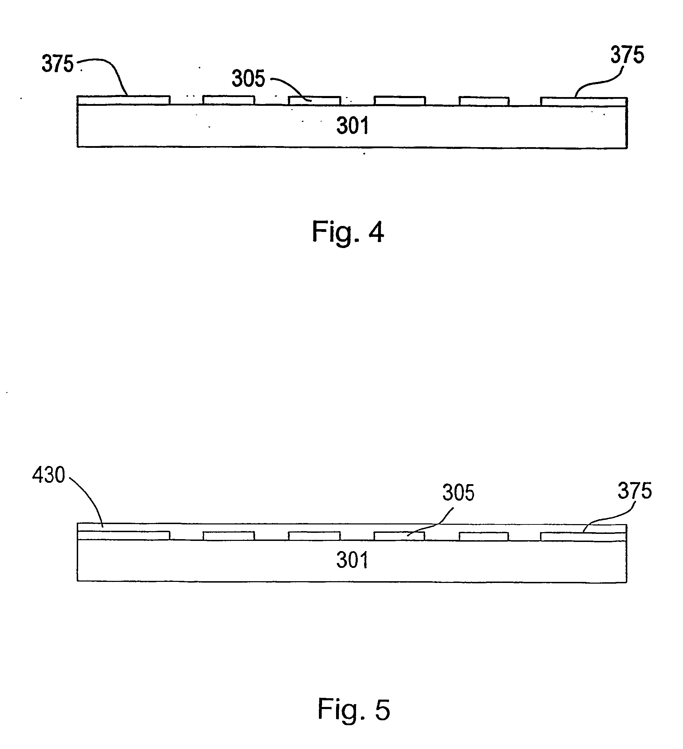

Figs. 4-9 show a process for fabricating an OLED device in accordance with one embodiment of the invention.

Referring to Fig. 4, a substrate 301 is provided. In one embodiment, the substrate comprises a transparent substrate, for example, soda lime or borosilicate glass. Other types of transparent materials can also be used to serve as the substrate. The substrate typically is about 0.4 - 1.1 mm thick.

In another embodiment, the substrate comprises a thin flexible substrate. Thin flexible substrates are formed from, for example, plastic films such as transparent poly(ethylene terephthalate) (PET), poly(butylene terephthalate) (PBT), poly(ethylene naphthalate) (PEN), polycarbonate (PC), polyimides (PI), polysulfones (PSO), and poly(p-phenylene ether sulfone) (PES). Other materials such as polyethylene (PE), polypropylene (PP), poly(vinyl chloride) (PVC), polystyrene (PS) and poly(methyl methyleacrylate) (PMMA), can also be used to form the substrate. Alternatively, materials such as ultra thin glass (e.g., thickness between 10-100 um), a composite stack comprising glass and polymer or polymer films coated with inorganic barrier layers can also be used.

The substrate is prepared with first electrodes 305. The first electrodes are located in at least the active region. The first electrodes serve as, for example, anodes. The anodes can be formed by, for example, depositing and patterning a conductive layer on the substrate. Various techniques, such as photolithography, can be used to pattern the conductive layer. In one embodiment, the anodes are arranged in strips in a first direction. Anodes having other patterns are also useful. In one embodiment, the conductive material comprises a transparent conductive material such as indium-tin-oxide (ITO). Other transparent conductive materials, for example, indium-zinc-oxide, zinc-oxide, tin-oxide, are also useful.

Interconnects 375 are provided on the substrate outside the active region. The interconnects are coupled to the electrodes. In one embodiment, a conductive layer is deposited over the substrate and patterned to form electrical interconnections 375 and bond pads. The conductive layer comprises, for example, a metal such as Al, Ag, Au or Cr. Patterning of the conductive layer can be achieved using conventional mask and etch techniques.

Referring to Fig. 5, a device layer 430 is deposited over the substrate. The device layer, in one embodiment, comprises photoresist. Various types of photoresist, for example, positive or negative acting, can be used. Other types of photosensitive materials or non-photosensitive materials which promote uniformity in the active polymer layer can also be used. If the device layer comprises a conductive material, an insulating layer is provided beneath it, if necessary, to prevent shorting of interconnects.

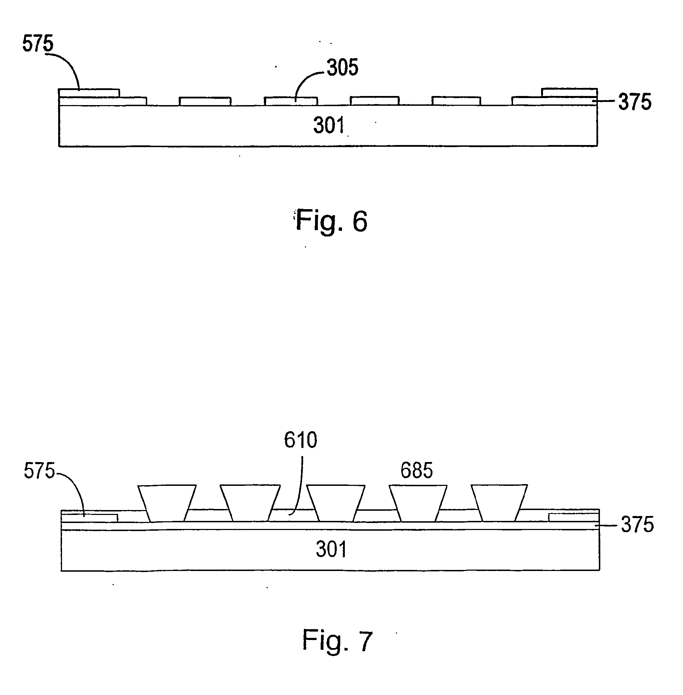

Referring to Fig. 6, the device layer is then patterned to form a homogenous layer 575 in the area outside the active region. If a photosensitive device layer is used, it is patterned by selectively exposing portions and removing the exposed or unexposed portions, depending on whether a positive or negative photosensitive material is used. On the other hand, conventional mask and etch techniques can be used to pattern a non-photosensitive device layer.

Referring to Fig. 7, the process continues to complete the fabrication of the OLED device. Various conventional techniques can be used to complete the OLED device. In one embodiment, shaped pillars 685 are formed on the substrate. The shaped pillars comprises an undercut, for example a v-shape profile, to sufficiently interrupt the conductive layer during deposition to form the electrodes. Preferably, the shaped pillars are formed from a single layer of material. In one embodiment, the shaped pillars are formed from a single layer comprising a negative photoresist. Other types of photosensitive materials can also be used. Non-photosensitive materials can also be used to form shaped pillars. Alternatively, the shaped pillars are formed from multiple layers to create a t-shaped profile. The multiple layers can be formed from photosensitive and/or non-photosensitive materials.

After the pillars are formed, a functional organic layer 610 is deposited on the substrate. In one embodiment, the functional organic layer comprises a conjugated polymer. Other types of organic materials are also useful. The polymer is deposited by spin-coating or doctor blading. Additional functional layers can be deposited to form a functional organic stack. Different types of polymers can be deposited to form a multi-color OLED device. The presence of a homogenous layer covering the metal layer outside the active region ensures a good uniform deposition of polymer layer. It therefore eliminates any unevenness formed outside the active region where metal is present from corrugating into the active region.

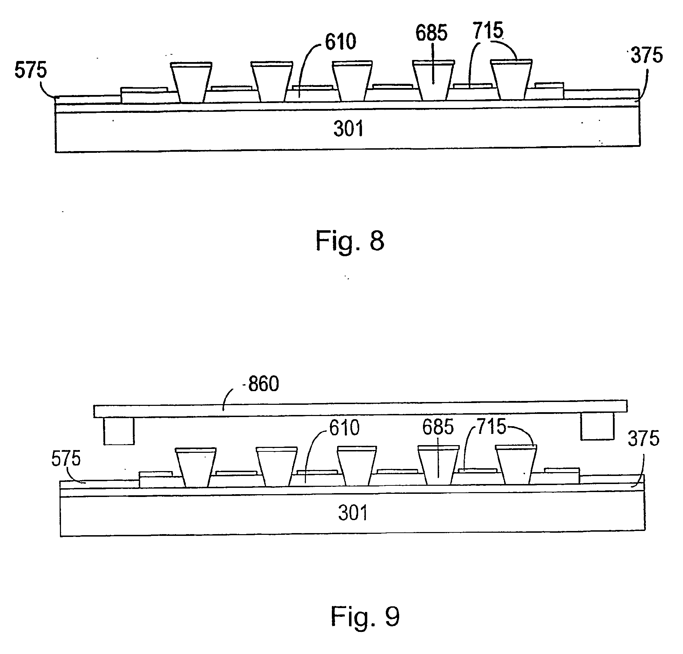

Referring to Fig. 8, a second conductive layer 715 is deposited on the substrate. The conductive layer comprises, for example, Ca, Mg, Ba, Ag, Al or a mixture or alloy thereof. Other conductive materials, particularly those comprising a low work function, can also be used to form the second conductive layer. Alternatively, the second conductive layer comprises an ionic compound, such as LiF, MgF, or CsF. In one embodiment, the second conductive layer comprises Ca. The Ca layer is deposited by, for example, thermal evaporation at a rate of 1 nm/s and a pressure of about 10⁻⁵ mbar. Alternatively, the second conductive layer comprises a composite layer or stack of multiple conductive layers. For example, the stack comprises a first layer of Ca followed by a second conductive layer of Ag or Al. Various deposition techniques, such as, thermal evaporation, sputtering (PVD), chemical vapor deposition (CVD), plasma enhanced chemical vapor deposition (PECVD) or metal organic chemical vapor deposition (MOCVD), can be used to form the second conductive layer. Preferably, a shadow mask is used to deposit the second conductive layer in the active area 585 of the device. The deposition of the second conductive layer is interrupted by the pillars, creating second electrodes or cathodes. The intersections of the cathodes and anodes form OLED cells.

The portions of the organic layer outside the active region are removed, as shown in Fig. 8. Etching can be done by, for example, laser ablation. In one embodiment, the organic material is removed prior to the formation of second electrodes. Patterning the organic layer after formation of the second electrodes can also be useful. To ensure that the organic material is completely removed, an overetch is performed. The overetch also partially removes the homogenous layer which also serves as the surface protection layer. However, no damage occurs in the metal interconnects from the laser ablation since they are protected by the surface protection layer.

As shown in Fig. 9, the OLED device is completed by mounting a cap 860 to the cap bonding region of the substrate. After the OLED device is encapsulated, part of the homogenous layer outside the active area can be removed to expose the interconnects to the electrodes using, for example, conventional mask and wet or dry etch techniques. Other techniques, for example, laser ablation can also be used to remove the homogenous layer. This can be done at an energy density of, for example, 0.3J/cm² and wavelength of 248nm.

In a preferred embodiment, the homogenous layer is formed as part of the existing process for fabricating the OLED device. For example, a portion of the homogenous layer can remain on the substrate after formation of bond pads and interconnects to serve as the surface protection layer.

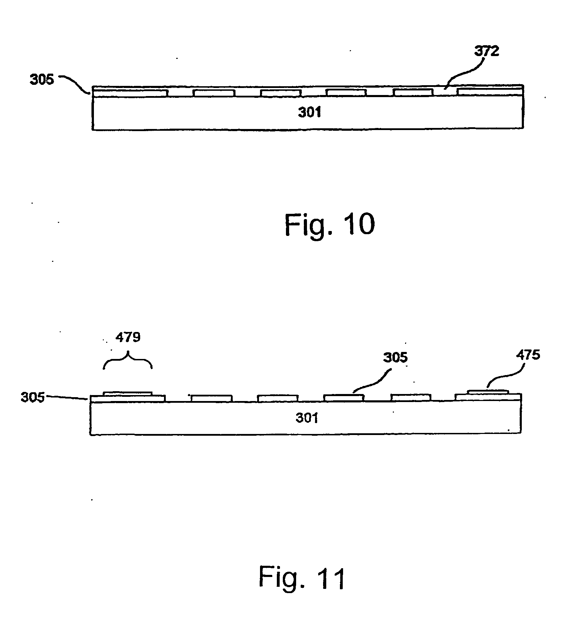

Figs. 10-14 show a process for fabricating an OLED device in accordance with one embodiment of the invention. Referring to Fig. 10, a substrate 301 is provided. In one embodiment, the substrate comprises a transparent substrate, for example, soda lime or borosilicate glass. Other types of transparent materials as described in Fig.4 can also be used.

The substrate includes first electrodes 305 formed on the surface thereof. The first electrodes serve as, for example, anodes. The anodes can be formed by, depositing and patterning a conductive layer on the substrate. Various techniques, such as photolithography, can be used to pattern the conductive layer. In one embodiment, the anodes are arranged in strips in a first direction. Anodes having other patterns are also useful. In one embodiment, the conductive material comprises a transparent conductive material such as indium-tin-oxide (ITO). Other transparent conductive materials, for example, indium-zinc-oxide, zinc-oxide, tin-oxide, are also useful.

Bond pads and other interconnects may also be included on the substrate. The bond pad and interconnects are formed by depositing and patterning a conductive layer. The conductive layer comprises, for example, a metal such as Al, Ag, Au, Cr. Patterning of the conductive layer can be achieved using conventional mask and etch techniques.

A device layer 372 is deposited over the substrate. The surface protection layer, in one embodiment, comprises photoresist. Various types of photoresist, for example, positive or negative acting, can be used. Other types of photosensitive materials or non-photosensitive materials can also be used. The device layer is then patterned to form a surface protection layer 475 in the cap bonding region of the substrate, as shown in Fig. 11. If a photosensitive device layer is used, it is patterned by selectively exposing portions and removing the exposed or unexposed portions, depending on whether a positive or negative photosensitive material is used. On the other hand, conventional mask and etch techniques can be used to pattern a non-photosensitive device layer.

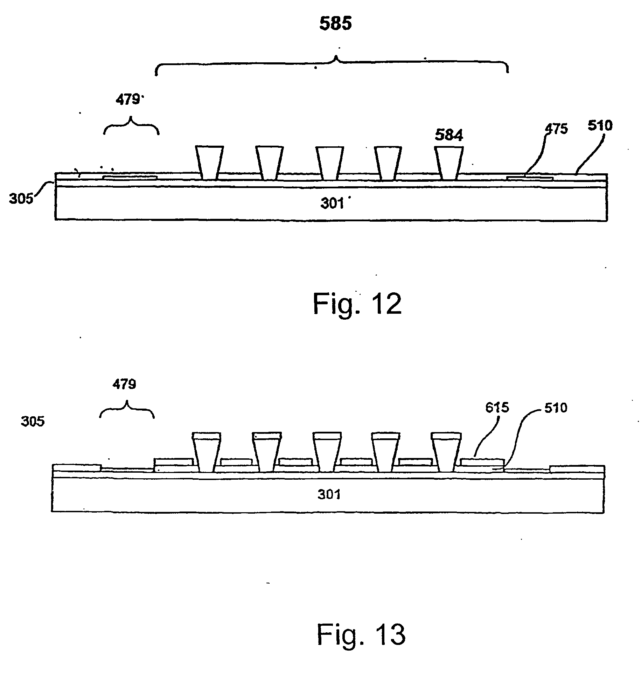

Referring to Fig. 12, the process continues to complete the fabrication of the OLED device. Various conventional techniques can be used to complete the OLED device. In one embodiment, shaped pillars 584 are formed on the substrate. The shaped pillars comprises an undercut, for example a v-shape profile, to sufficiently interrupt the conductive layer during deposition to form the electrodes. Preferably, the shaped pillars are formed from a single layer of material. In one embodiment, the shaped pillars are formed from a single layer comprising a negative photoresist. Other types of photosensitive materials can also be used. Non-photosensitive materials can also be used to form shaped pillars. Alternatively, the shaped pillars are formed from multiple layers to create a t-shaped profile. The multiple layers can be formed from photosensitive and/or non-photosensitive materials.

After the pillars are formed, a functional organic layer 510 is deposited on the substrate. In one embodiment, the functional organic layer comprises a conjugated polymer. Other types of polymer materials are also useful. The polymer is deposited by, for example, spin-coating. Other deposition techniques can also be used. Additional functional layers can be deposited to form a functional organic stack. Different types of polymers can be deposited to form a multi-color OLED device.

Referring to Fig. 13, a second conductive layer 615 is deposited on the substrate. The conductive layer comprises, for example, Ca, Mg, Ba, Ag, Al or a mixture or alloy thereof. Other conductive materials, particularly those comprising a low work function, can also be used to form the second conductive layer. Alternatively, the second conductive layer comprises an ionic compound, such as LiF, MgF, or CsF. In one embodiment, the second conductive layer comprises Ca. The Ca layer is deposited by, for example, thermal evaporation at a rate of 1 nm/s and a pressure of about 10⁻⁵ mbar. Alternatively, the second conductive layer comprises the same composite layer or stack of multiple conductive layers as described in Fig. 8. This arrangement of layers is also deposited on the substrate the same way as described in Fig. 8.

The polymer layer in the cap bonding region is removed or etched by, for example, laser ablation. In one embodiment, the polymer is removed prior to the formation of second electrodes. Patterning the polymer layer after formation of the second electrodes can also be useful. To ensure that the polymer is completely removed, an overetch is performed. The overetch also partially removes the surface protection layer. However, no damage occurs in the metal interconnects from the laser ablation since they are protected by the surface protection layer.

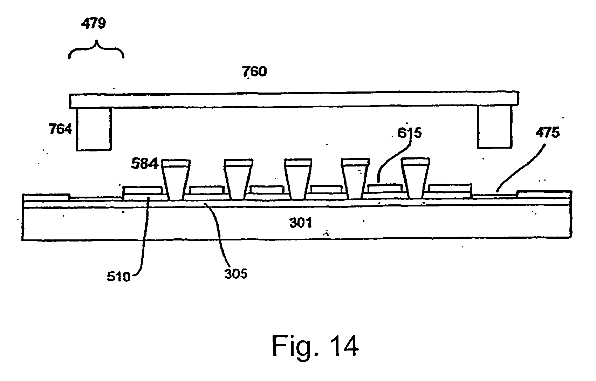

As shown in Fig. 14, the OLED device is completed by mounting a cap 760 to the cap bonding region of the substrate. The surface protection layer and cap sealing rim forms an interface between the cap and substrate. An adhesive resin can be used to bond the cap to the substrate. In one embodiment, the adhesive exhibits good bonding and barrier property between the substrate and cap to hermetically seal the OLED cells. Various types of resins, such as those based on epoxies, silicons, urethanes, acrylates or olefins can be used. The resin can either be a UV or thermally curable resin. Through the use of a protection layer, there is flexibility in designing a sealing system (e.g., adhesive, cap material, and protection layer material) having the desired properties.

After the OLED device is encapsulated, the polymer material outside the active area can be removed to expose the bond pads using, for example, a wet etch. Since the active area of the device is sealed, the chemicals will not adversely impact the OLED cells.

In a preferred embodiment, the surface protection layer is formed as part of the existing process for fabricating the OLED device. A portion of the resist layer remains on the substrate after the formation bond pads and interconnects to serve as the surface protection layer. Alternatively, the device layer used to form the shaped pillars can advantageously be patterned to include the surface protection layer.

## Claims

1. A process for fabricating an OLED device, comprising:
- providing a substrate (201) having an active region (285) and a cap bonding region surrounding the active region (285),
wherein the substrate (201) is prepared with a first electrode (205) at least located in the active region and metal interconnections located outside the active region;
- forming a homogenous layer (275) covering the metal interconnections in an area outside the active region (285) of the substrate (201), wherein the homogenous layer (275) serves as a surface protection layer and comprises a non-conductive material, wherein forming the homogenous layer (275) comprises depositing a device layer (430) over the substrate (201) and patterning the device layer (430) to form the homogenous layer (275) in the area outside the active region (285);
- depositing at least one organic layer (210) comprising organic material on the substrate (201) by spin-coating or doctor blading;
- forming a second electrode (215), wherein the organic layer (210) is sandwiched between the first electrode (205) and the second electrode (215) and the metal interconnections are coupled to the electrodes (205, 215);
- removing the portions of the at least one organic layer (210) in the area outside the active region (285), wherein the at least one organic layer (210) is removed prior the formation of the second electrode (215);
- mounting a cap to the cap bonding region;
wherein the homogenous layer (275) promotes coating uniformity of the organic layer (210) on the substrate (201) and hence reducing or preventing the adverse effect of metal, and allows removal of organic material from the at least one organic layer (210) without damaging a layer below the homogenous layer (275).

2. The process according to the preceding claim, wherein the at least one organic layer (210) is removed by an overetch.

3. The process according to claim 2, wherein during the removing of the at least one organic layer (210) the homogenous layer (275) is also partially removed.

4. The process according to one of the claims 1 to 3, wherein the homogenous layer (275) comprises a photosensitive material or a non-photosensitive material, which comprises polyimide.

## Patentansprüche

1. Prozess zur Herstellung eines OLED-Bauelements, umfassend:
- Bereitstellen eines Substrats (201) mit einem aktiven Gebiet (285) und einem Kappen-Bonding-Gebiet, das das aktive Gebiet (285) umgibt,
wobei das Substrat (201) mit einer ersten Elektrode (205), die sich zumindest im aktiven Gebiet befindet, und Metallzwischenverbindungen, die sich außerhalb des aktiven Gebiets befinden, versehen wird;
- Ausbilden einer homogenen Schicht (275), die die Metallzwischenverbindungen in einem außerhalb des aktiven Gebiets (285) des Substrats (201) liegenden Bereich bedeckt, wobei die homogene Schicht (275) als Oberflächenschutzschicht dient und ein nichtleitfähiges Material umfasst,
wobei Ausbilden der homogenen Schicht (275) Abscheiden einer Bauelementschicht (430) über das Substrat (201) und Strukturieren der Bauelementschicht (430) zur Ausbildung der homogenen Schicht (275) in dem außerhalb des aktiven Gebiets (285) liegenden Bereich umfasst;
- Abscheiden mindestens einer organisches Material umfassenden organischen Schicht (210) auf dem Substrat (201) durch Aufschleudern oder Rakeln;
- Ausbilden einer zweiten Elektrode (215), wobei die organische Schicht (210) zwischen der ersten Elektrode (205) und der zweiten Elektrode (215) angeordnet ist und die Metallzwischenverbindungen mit den Elektroden (205, 215) gekoppelt sind;
- Entfernen der Abschnitte der mindestens einen organischen Schicht (210) im außerhalb des aktiven Gebiets (285) liegenden Bereich,
wobei die mindestens eine organische Schicht (210) vor der Ausbildung der zweiten Elektrode (215) entfernt wird;
- Aufbringen einer Kappe auf das Kappen-Bonding-Gebiet;
wobei die homogene Schicht (275) eine Beschichtungsgleichmäßigkeit der organischen Schicht (210) auf dem Substrat (201) fördert und somit den nachteiligen Effekt von Metall reduziert oder verhindert und die Entfernung von organischem Material von der mindestens einen organischen Schicht (210), ohne eine Schicht unter der homogenen Schicht (275) zu beschädigen, zulässt.

2. Prozess nach dem vorhergehenden Anspruch, wobei die mindestens eine organische Schicht (210) durch eine Überätzung entfernt wird.

3. Prozess nach Anspruch 2, wobei während der Entfernung der mindestens einen organischen Schicht (210) die homogene Schicht (275) auch teilweise entfernt wird.

4. Prozess nach einem der Ansprüche 1 bis 3,
wobei die homogene Schicht (275) ein photoempfindliches Material oder ein nicht-photoempfindliches Material umfasst, das Polyimid umfasst.

## Revendications

1. Procédé de fabrication d'un dispositif OLED, comprenant :
- l'obtention d'un substrat (201) ayant une région active (285) et une région d'assemblage de couvercle entourant la région active (285),
le substrat (201) étant préparé avec une première électrode (205) au moins située dans la région active et des interconnexions métalliques situées à l'extérieur de la région active ;
- la formation d'une couche homogène (275) recouvrant les interconnexions métalliques dans une zone à l'extérieur de la région active (285) du substrat (201), la couche homogène (275) servant de couche de protection de surface et comprenant un matériau non conducteur, la formation de la couche homogène (275) comprenant le dépôt d'une couche de dispositif (430) sur le substrat (201) et la structuration de la couche de dispositif (430) pour former la couche homogène (275) dans la zone à l'extérieur de la région active (285) ;
- le dépôt d'au moins une couche organique (210) comprenant un matériau organique sur le substrat (201) par dépôt à la tournette ou enduction à la racle ;
- la formation d'une deuxième électrode (215), la couche organique (210) étant intercalée entre la première électrode (205) et la deuxième électrode (215) et les interconnexions métalliques étant couplées aux électrodes (205, 215) ;
- le retrait des parties de l'au moins une couche organique (210) dans la zone à l'extérieur de la région active (285), l'au moins une couche organique (210) étant retirée avant la formation de la deuxième électrode (215) ;
- le montage d'un couvercle sur la région d'assemblage de couvercle ;
la couche homogène (275) favorisant l'uniformité de dépôt de la couche organique (210) sur le substrat (201) et réduisant ou empêchant ainsi l'effet indésirable du métal, et permettant le retrait du matériau organique de l'au moins une couche organique (210) sans endommager une couche en dessous de la couche homogène (275).

2. Procédé selon la revendication précédente, dans lequel l'au moins une couche organique (210) est retirée par une surgravure.

3. Procédé selon la revendication 2 dans lequel, pendant le retrait de l'au moins une couche organique (210), la couche homogène (275) est également retirée partiellement.

4. Procédé selon l'une des revendications 1 à 3, dans lequel la couche homogène (275) comprend un matériau photosensible ou un matériau non photosensible, qui comprend un polyimide.
